# EUROPÄISCHE PATENTSCHRIFT

(11) **EP 4 154 027 B1**
(45) Veröffentlichungstag und Bekanntmachung des Hinweises auf die Patenterteilung: **15.05.2024**
(21) Anmeldenummer: 21762465.9
(22) Anmeldetag: 13.08.2021
(51) Int. Cl.: G01R 31/34, G01R 23/165, G01R 19/00

(54) **MASCHINENZUSTANDSÜBERWACHUNGSVERFAHREN UND -SYSTEM**
MACHINE CONDITION MONITORING METHOD AND SYSTEM
PROCÉDÉ ET SYSTÈME DE SURVEILLANCE DE L'ÉTAT D'UNE MACHINE

(30) Priorität: 28.08.2020 EP 20193335
(43) Veröffentlichungstag der Anmeldung: 29.03.2023
(73) Patentinhaber: Siemens Aktiengesellschaft, 80333 München (DE)
(72) Erfinder: ZETTNER, Jürgen, 90587 Veitsbronn (DE)
(74) Vertreter: Siemens Patent Attorneys
(86) Internationale Anmeldenummer: PCT/EP2021/072634
(87) Internationale Veröffentlichungsnummer: WO 2022/043101

(56) Entgegenhaltungen:
- WO-A1-2015/047121
- KAR C ET AL: "Monitoring gear vibrations through motor current signature analysis and wavelet transform", MECHANICAL SYSTEMS AND SIGNAL PROCESSING, ELSEVIER, AMSTERDAM, NL, Bd. 20, Nr. 1, 22. September 2004 (2004-09-22), Seiten 158-187, XP024930287, ISSN: 0888-3270, DOI: 10.1016/J.YMSSP.2004.07.006 [gefunden am 2006-01-01]

## Beschreibung

Die Erfindung betrifft ein computerimplementiertes Verfahren, und ein System zur Zustandsüberwachung einer elektrischen Maschine.

Außerdem betrifft die Erfindung einen Computerprogrammcode mit den Befehlen zum Ausführen des vorgenannten Verfahrens. Obendrein betrifft die Erfindung ein Datenträgersignal, das den vorgenannten Computerprogrammcode überträgt.

In der Überwachung elektrischer Maschinen wird die sog. Stromsignaturanalyse (engl. Motor Current Signature Analysis", MCSA) als ein mögliches Condition Monitoring (CM) Tool verwendet und ist im Stand der Technik wohl bekannt (vgl. D. Miljković "Brief Review of Motor Current Signature Analysis". CrSNDT Journal. 5. 14-26. (2015); H. W. Penrose, "Practical Motor Current Signature Analysis: Analysis: Taking the Mystery Out of MCSA Taking the Mystery Out of MCSA", ALL-TEST Pro" (2003); C. Kar and A. R. Mohanty, "Monitoring gear vibrations through motor current signature analysis and wavelet transform", Mechanical Systems and Signal Processing, Vol. 20, Issue 1, January 2006, pp. 158-187).

WO 2015/047121 A1 beschreibt ein Verfahren zur Betriebsüberwachung und Fehlervorhersage in einem System, das einen antriebsbetriebenen Motor enthält, basierend auf einer auf Antriebsebene durchgeführten Motor Current Signature Analysis (MCSA), umfassend: Sammeln von Motorstromdaten durch einen Zustandsmonitor, die aus einem Motorstromsignal gewonnen werden, das über eine HM-Schnittstelle verfügbar ist, die von einem bestimmten Antrieb unterstützt wird, Verarbeitung der gesammelten Daten durch MCSA auf Antriebs-Firmware-Ebene, Treffen einer Entscheidung über den Betriebszustand und Vorhersagen eines Fehlers auf Grundlage von Ergebnissen der Verarbeitung.

Bei der MCSA wird beispielsweise eine Fouriertransformation (FFT) angewandt, um Fehler- und/oder Betriebszustände elektrischer Maschinen im Frequenzbereich zu detektieren bzw. zu quantifizieren. Die klassische MCSA ist dabei im quasistationären Fall angewandt, d.h. in dem Fall nominell konstanter Drehzahl. Eine Erweiterung der MCSA stellt die Analyse mit Kurzzeit-FFTs oder Wavelets dar, um Vorgänge zeitaufgelöst zu analysieren.

Ergänzend zur MCSA können Spektralanteile der Spannung (MVSA) herangezogen werden, um die Zustandsüberwachung zu betreiben (vgl. Kumar, K. (2011). "A Review of Voltage and Current Signature Diagnosis in Industrial Drives". International Journal of Power Electronics and Drive Systems (IJPEDS). 1. 10.11591/ijpeds.v1i1.64).

Dabei werden - im Fall von dreiphasigen Motoren - drei elektrischen Phasen (R, S, T) der Antriebstechnik erfasst. Messmittel messen neben dem Strom I auch die Spannung U der Phasen. Die Messung erfolgt mit hoher Abtastfrequenz und so gut wie möglich zeitsynchron.

Eine Aufgabe der MCSA ist eine möglichst genaue Ermittlung des Schlupfs von Asynchronmaschinen (ASM). Ändern sich nämlich die Lastzustände auch nur geringfügig, so reagiert die ASM mit einer Anpassung der Drehzahl. Eine Möglichkeit den Schlupf genau zu bestimmen ist durch die Frequenzbestimmung der sog. Principal Slot Harmonics (PSH). Dazu können die PSH Frequenzen f_{PSH}, die eine Funktion der Rotorstabzahl R, der Polpaarzahl p und des Schlupfs s ist (f_{PSH} = func(R,p,s)), in einer oder mehrere elektrischen Phasen (R,S,T) der erfassten Ströme im jeweiligen ausgewertet werden. Ein Problem dabei ist, dass sich die Amplituden außerhalb der Netzspeisefrequenz f0 (üblicherweise 50 Hz oder 60 Hz) als sehr klein <1e-2*A(f0) im Vergleich zu Amplitude des Speisestromes (A(f0)) äußern. Die erfassten Stromamplituden in den Frequenzbereichen der PSH können sehr klein werden und sind je nach erforderlicher Zeitauflösung der Auswertung mit Rauschen und Störungen behaftet, welche im Bereich der zu ermittelnden Amplituden zur Schlupferkennung liegen können. Eine dynamische Schlupferkennung mit PSH ist daher anfällig für Störungen und ist mithin zu ungenau. Störungen können u.a. die Netzspannungsanteile sonstiger Verbraucher im Speisenetz sein.

Die vorgenannten Nachteile betreffen allerdings nicht nur eine Frequenzbestimmung bei den PSH. Vielmehr bestehen ähnliche Probleme bei allen Frequenzbestimmungen der MCSA, die auf die Erkennung von Abweichungen oder Fehlern hindeuten und eine Zustandsüberwachungsdiagnose ermöglichen sollten. Fehler wie Rotorstabbruch, Exzentrizitäten, Lagerfehler, Einfluss gekoppelter Maschinen, aber eben auch der Lastzustand der Maschine sind im Stand der Technik der MCSA im Stromspektrum bei bekannten diesen Fehler- beziehungsweise Betriebszuständen zuordbaren Frequenzen zu detektieren.

Werden beispielsweise Amplituden bei jenen Frequenzen gefunden/ermittelt, die für einen bestimmten Fehler- beziehungsweise Betriebszustand, zum Beispiel eine Exzentrizität des Luftspaltes charakteristisch sind, so ist es auf den vorgenannten bestimmten Fehler- beziehungsweise Betriebszustand der elektrischen Maschine zurückzuführen.

Die MCSA bedient sich der Annahme konstanter Verhältnisse und der Mittelwertbildung über lange Zeiten (typische Messzeiten sind dabei ca. 30s) um das SNR (engl. signal noise ratio) der Signale zu verbessern. Dabei kann lediglich ein gemittelter Schlupf über der Messzeit, beziehungsweise eine Fehleramplitude aus gemittelten Werten der zugehörigen Amplituden bei Schadfrequenzen ermittelt werden.

Die Aufgabe der vorliegenden Erfindung kann somit darin gesehen werden, die Zustandsüberwachungsverfahren und -systeme für die elektrischen Maschinen weiterzubilden und eine dynamische Frequenzlagen- bzw. Frequenzlinienerkennung und beispielsweise eine dynamische Schlupferkennung zu ermöglichen.

Dabei ist die Erfindung durch das computerimplementierte Verfahren nach Anspruch 1, den Computerprogrammcode nach Anspruch 10, das System nach Anspruch 11 und das Datenträgersignal nach Anspruch 13 definiert.

Die Aufgabe wird mit einem eingangs genannten Verfahren erfindungsgemäß dadurch gelöst, dass innerhalb eines definierten Frequenzbereichs, beispielsweise in einem (durch eine Messung aufgenommenen) Spektrogramm einer Stromamplitude, eine Frequenzlage derart ermittelt wird, dass bei der Frequenzlage die Stromamplitude maximal ist und eine Phasenbeziehung zwischen einem Strom- und einem Spannungsvektor oder zwischen zwei Stromvektoren in einem vorbestimmten Intervall liegt, wobei die ermittelte Frequenzlage für einen Zustand der elektrischen Maschine charakteristisch ist.

Mit anderen Worten wird bei der Ermittlung der Frequenzlinie die Stromamplitude und eine Phasenbeziehung zwischen einem Strom- und einem Spannungsvektor oder zwischen zwei Stromvektoren (abhängig von der Frequenz) ermittelt und geprüft, ob die Stromamplitude bei der Frequenz maximal ist und (gleichzeitig) die Phasenbeziehung zwischen einem Strom- und einem Spannungsvektor oder zwischen zwei Stromvektoren (bei der Frequenz) in einem vorbestimmten Intervall liegt. Wird dabei festgestellt, dass diese zwei Bedingungen erfüllt sind, d. h. die Stromamplitude maximal ist und die Phasenbeziehung zwischen einem Strom- und einem Spannungsvektor oder zwischen zwei Stromvektoren in einem vorbestimmten Intervall liegt, wird die Frequenz, bei der die zwei Bedingungen positiv geprüft worden sind, als eine Frequenz der zu ermittelnden Frequenzlinie bzw. -lage festgelegt.

Das Intervall wird derart vorbestimmt, dass die Frequenzlage (die interessante Frequenzlinie = die "Hauptlinie") eine erste (absolute) Phasenlage (z.B. 60 bis 80°) aufweist, die vorzugsweise wohldefiniert ist, wohingegen die Störlinien z.B. Seitenbandlinien eine davon abweichende Phasenlage (z.B. 0 bis 20°) aufweisen. Das Intervall wird somit vorbestimmt, um zwischen der(n) Hauptlinie(n) und den Störlinien zu unterscheiden. "Vorbestimmt" bezieht sich somit auf die Unterscheidbarkeit der Hauptlinie(n) von Störlinien in der Phase. Mit anderen Worten ist die Auswahl eines "vorbestimmten" (Phasen-)Intervalls (in einem Frequenzband um die Hauptlinie herum) derart zu treffen, dass die Unterscheidbarkeit zu Phasenlagen von störenden Linien ermöglicht, vorzugsweise vergrößert, insbesondere maximiert wird.

Es kann zweckdienlich sein, den Frequenzbereich derart zu definieren, dass in dem Frequenzbereich zumindest eine für einen Zustand der elektrischen Maschine charakteristische Frequenzlinie liegt bzw. liegen könnte (die mögliche Lage einer Frequenzlinie kann beispielsweise unter Verwendung des MCSA-Verfahrens erfolgen). Hierdurch kann eine Zuordnung eines Frequenzbereichs zu einer für einen Zustand der elektrischen Maschine charakteristischen Frequenzlinie stattfinden.

Zusammenfassend wird bei dem Verfahren innerhalb eines definierten Frequenzbereichs, beispielsweise in einem (durch eine Messung aufgenommenen) Spektrogramm einer Stromamplitude, eine Frequenzlage bzw. -linie abhängig von der Stromamplitude und von einer Phasenbeziehung zwischen einem Strom- und einem Spannungsvektor oder zwischen zwei Stromvektoren ermittelt. Dabei soll die Stromamplitude maximiert und die Phasenbeziehung in einem vorbestimmten Intervall liegen. Die ermittelte Frequenzlage bzw. -linie ist für einen Zustand der elektrischen Maschine charakteristisch.

Wie bereits beschrieben, ist die ermittelte Frequenzlage bzw. -linie einem (bestimmten) Zustand der elektrischen Maschine zugeordnet und erlaubt somit, über diesen (bestimmten) Maschinenzustand Rückschlüsse zu ziehen.

Bei einer Ausführungsform kann mit Vorteil vorgesehen sein, dass innerhalb mehrerer unterschiedlicher, vorzugsweise sich nicht überlappender, vorbestimmter Frequenzbereiche jeweils eine Frequenzlage ermittelt wird, wobei unterschiedliche Frequenzlagen bzw. -linien für unterschiedliche Zustände der elektrischen Maschine charakteristisch sind.

Bei einer Ausführungsform kann es zweckdienlich sein, wenn die elektrische Maschine eine Drehstrommaschine ist und der Zustand der Maschine ein Fehler- oder Betriebszustand ist.

Bei einer Ausführungsform kann es vorteilhaft sein, wenn die Drehstrommaschine eine Asynchronmaschine ist und der Frequenzbereich durch einen Schlupfbereich zwischen 0 und Kippschlupf bestimmt wird, insbesondere durch einen Schlupfbereich zwischen etwa 5% und etwa 10% (typische Schlupfwerte für Asynchronmaschinen 5 bis 30 KW) bestimmt wird.

Bei einer Ausführungsform kann mit Vorteil vorgesehen sein, dass die Drehstrommaschine eine Synchronmaschine ist und der Zustand ein Fehlerzustand ist. In diesem Fall wird kein Schlupf und somit keine Lastauswertung wie bei ASM durchgeführt dafür aber eine Fehlerfrequenzauswertung vorgenommen.

Bei einer Ausführungsform kann es zweckmäßig sein, wenn die Phasenbeziehung eine Phasenbeziehung zwischen einem α- und einem β-Stromvektor ist. Die α-, β-Stromvektoren sind die Stromvektoren, die sich aus einer Clarke-Transformation bzw. einer α,β-Transformation ergeben. Diese Transformation ist dem Fachmann geläufig und dient dazu, mehrphasige Größen wie bei einer Drehstrommaschine mit den Achsen U, V, W, ... in ein einfacheres zweiachsiges Koordinatensystem mit den Achsen α, β zu überführen.

Bei einer Ausführungsform kann vorgesehen sein, dass das vorbestimmte Intervall ein Intervall zwischen etwa 40° und etwa 90°, vorzugsweise zwischen etwa 40° und etwa 60° oder zwischen etwa 70° und etwa 90°, insbesondere zwischen etwa 80° und etwa 90° ist.

Bei einer Ausführungsform kann vorgesehen sein, dass die Phasenbeziehung aus bzw. anhand oder unter Verwendung von Admittanz oder Impedanz ermittelt wird.

Bei einer Ausführungsform kann mit Vorteil vorgesehen sein, dass die Stromamplitude mit einer vorbestimmten Messzeit gemessen wird, die beispielsweise zwischen etwa 0,1 Sekunde und 10 Sekunden, beispielsweise zwischen etwa 1 Sekunde bis 10 Sekunden, vorzugsweise zwischen etwa 1 Sekunde bis 5 Sekunden, insbesondere 1 Sekunde beträgt.

Um Spektrogramme zu erzeugen ist es möglich, eine, wie oben beschrieben, kurze Messzeit für Strom und/oder Spannung zu wählen. Dies ist vorteilhaft und ermöglicht eine dynamische Betriebs- und/oder Fehlerzustandsbewertung. Dabei ist die Messzeit kürzer als die Messzeit bei der typischen MCSA, die etwa bei 30 Sekunden liegt.

Die Aufgabe wird außerdem mit einem eingangs genannten System erfindungsgemäß dadurch gelöst, dass das System eine Recheneinheit umfasst, wobei die Recheneinheit einen Computerprogrammcode aufweist, wobei der Computerprogrammcode Befehle umfasst, die bei der Ausführung des Programmcodes durch die Recheneinheit diese veranlassen, das vorgenannte Verfahren auszuführen.

Bei einer Ausführungsform kann es zweckdienlich sein, wenn das System zusätzlich eine Messeinheit zur Messung von Strom und/oder Spannung einer dreiphasigen Drehstrommaschine insbesondere einer Synchron- oder einer Asynchronmaschine aufweist.

Die erfindungsgemäßen Zustandsüberwachungsverfahren und - system ermöglichen, eine Frequenzlage in einem vorbestimmten Frequenzbereich mit der maximalen Amplitude robuster und genauer zu bestimmen. Daraus kann z.B. Schlupf robuster bestimmt werden und/oder Störungen zuverlässiger ausgeschlossen werden. Dies ermöglicht beispielsweise eine dynamische Messung z.B. von Lastvariationen, eine Kenntnis des Schlupfes im Sekundentakt usw.

Im Folgenden wird die Erfindung anhand der in den Figuren dargestellten Ausführungsbeispiele näher beschrieben und erläutert. Es zeigen:
FIG 1 ein Flussdiagramm eines computerimplementierten Verfahrens zur Zustandsüberwachung einer elektrischen Maschine,
FIG 2 einen Ausschnitt eines Spektrogramms,
FIG 3 eine Phasenbeziehung zwischen einem Strom- und einem Spannungsvektor,
FIG 4 mit und ohne Berücksichtigung der Phasenbeziehung der

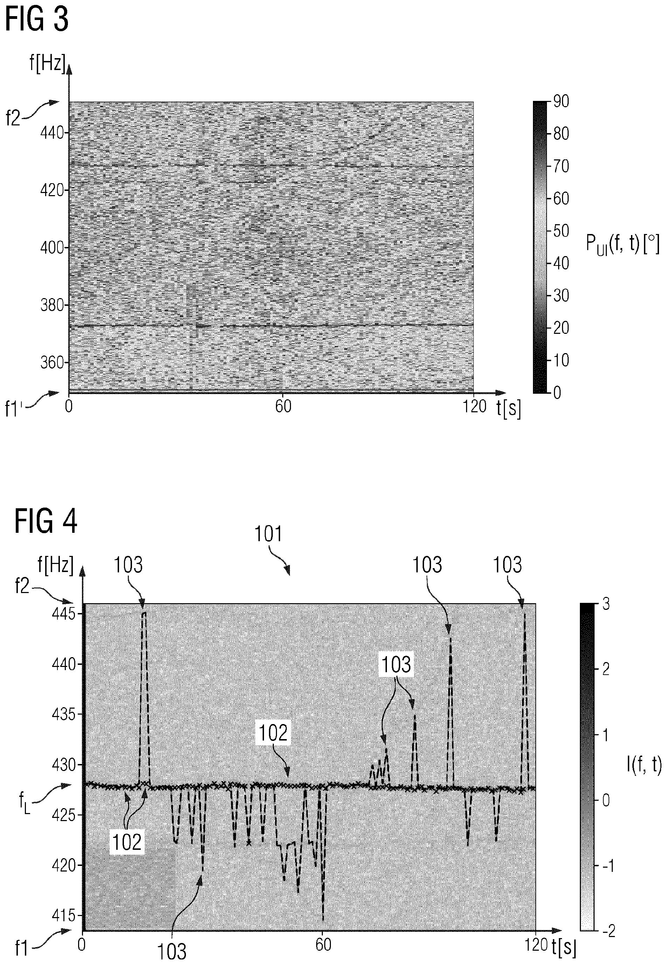

FIG 3 ermittelte Phasenlagen,

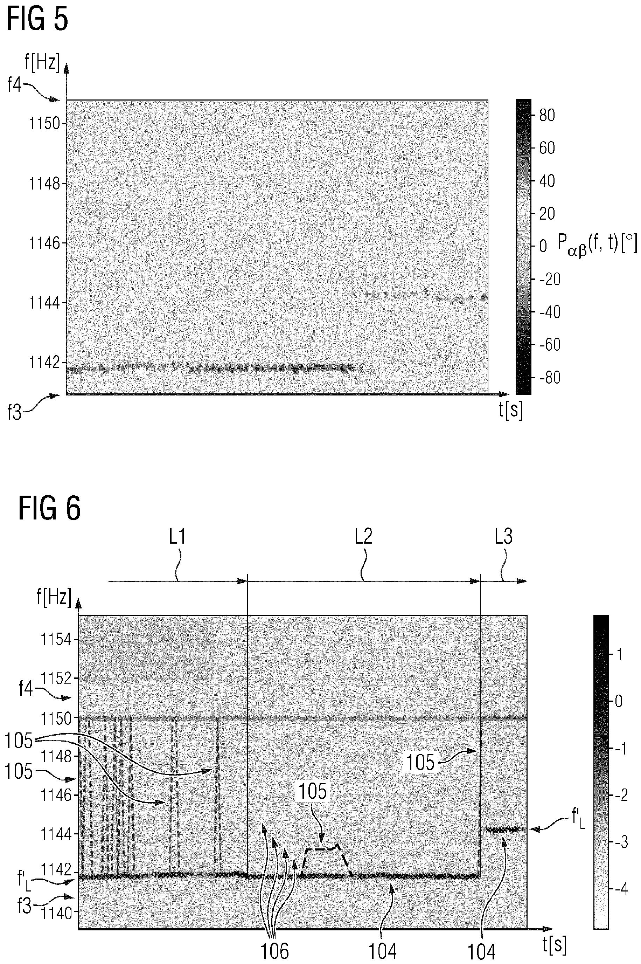

FIG 5 eine Phasenbeziehung zwischen einem α- und einem β-Stromvektor
FIG 6 mit und ohne Berücksichtigung der Phasenbeziehung der
FIG 5 ermittelte Phasenlagen, und

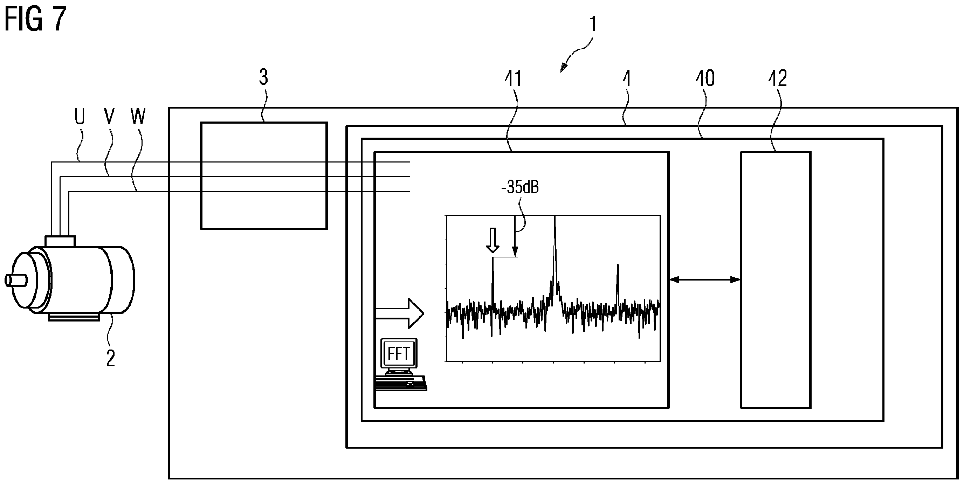

FIG 7 ein Zustandsüberwachungssystem für einen Asynchronmotor.

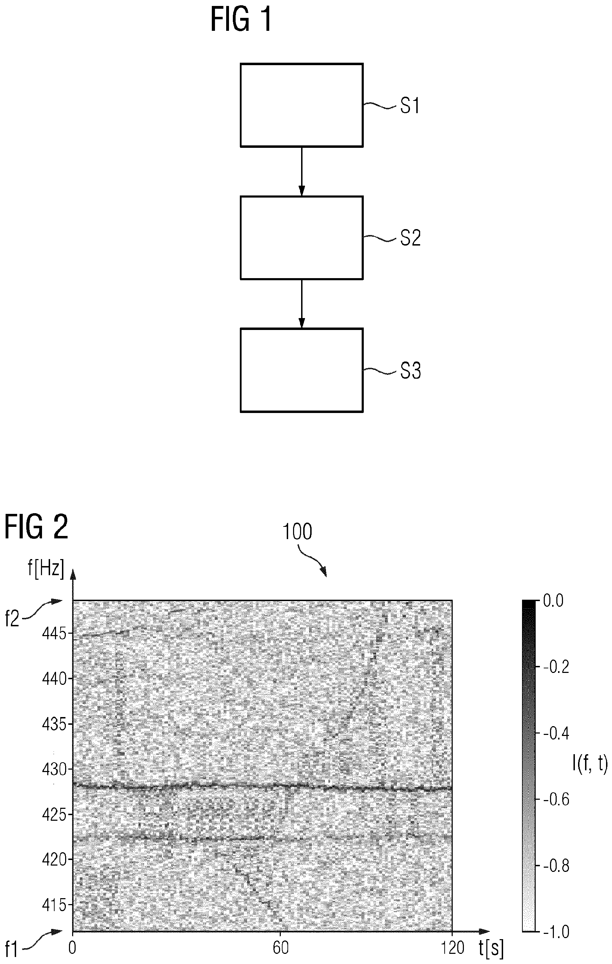

Fig 1 zeigt ein Flussdiagramm eines computerimplementierten Verfahrens zur Zustandsüberwachung einer elektrischen Maschine, wobei das computerimplementierte Verfahren einer Ausführungsform des erfindungsgemäßen Verfahrens entspricht.

In einem Schritt des Verfahrens S1 kann ein Spektrogramm I(f,t) einer Stromamplitude (anhand der gemessenen Stromwerte) erzeugt werden. Ein beispielhafter Ausschnitt (Frequenzen zwischen etwa 410 Hz und 450 Hz) des Spektrogramms 100 ist in Fig 2 gezeigt. Der Ausschnitt zeigt einen definierten Frequenzbereich (f1, f2) - hier zwischen etwa 410 Hz (f1) und etwa 450 Hz (f2). Bei Drehstrommaschinen, insbesondere bei Asynchronmaschinen kann der definierte Frequenzbereich (f1, f2) eine der bekannten Schadfrequenzen, wie z.B. eine Rotorstabbruchfrequenz umfassen, die zuvor mit einem Stromsignaturanalyseverfahren (engl. Motor Current Signature Analysis MCSA) nach dem Stand der Technik ermittelt wurden.

In einem Schritt des Verfahrens S2 wird eine Phasenbeziehung (in Grad) beispielsweise zwischen einem Strom- und einem (zuvor gemessenen) Spannungsvektor (I und U) berechnet. Der berechnete Phasenwinkel P_{UI}(f,t) zwischen dem Strom- und Spannungsvektor für das Spektrogramm 100 in einem Frequenzbereich (f1', f2) zwischen etwa 350 Hz (f1') und etwa 450 Hz (f2) ist Fig 3 zu entnehmen. Die Phasenbeziehung P_{UI}(f,t) kann beispielsweise aus bzw. anhand oder unter Verwendung von Admittanz oder Impedanz ermittelt werden.

Eine Strom- und/oder Spannungsmessung, die zur Erzeugung des Spektrogramms 100 und/oder der Phasenbeziehung dient, kann mit einer vorbestimmten Messzeit erfolgen. Besonders vorteilhaft ist eine Strom- und/oder Spannungsmessung, die eine Messzeit pro Messung von etwa 0,1 Sekunde bis 10 Sekunden, insbesondere eine Sekunde hat. Dies ermöglicht eine dynamische Betriebs- und/oder Fehlerzustandsbewertung. Dabei ist die Messzeit kürzer als die Messzeit bei einer typischen Stromsignaturanalyse (MCSA), bei der die Messzeit bei etwa 30 Sekunden liegt.

In einem Schritt des Verfahrens S3 wird innerhalb des definierten Frequenzbereichs (f1, f2) (vgl. das Spektrogramm 100 oder 101) eine Frequenzlage f_{L} derart ermittelt, dass bei der Frequenzlage f_{L} die Stromamplitude I(f,t) maximal ist und die Phasenbeziehung P_{UI}(f,t) in einem vorbestimmten Intervall liegt.

Die Frequenzlage f_{L} kann beispielsweise einer Principal Slot Harmonics (PSH) einer dreiphasigen Asynchronmaschine entsprechen, wobei die Frequenz f_{PSH}(7n) beispielsweise etwa 427Hz ist.

Die PSH Frequenzen sind eine Funktion der Rotorstabzahl R, der Polpaarzahl p und des Schlupfs s (f_{PSH} = func(R,p,s)). Wird nun eine PSH Frequenz genauer/zuverlässiger bestimmt, kann auch beispielsweise der Schlupf genauer/zuverlässiger bestimmt werden.

Insbesondere bei Drehstrommaschinen kann der Frequenzbereich (f1, f2) durch einen Schlupfbereich zwischen 0 und Kippschlupf, insbesondere durch einen Schlupfbereich zwischen etwa 5% und etwa 10% gegeben sein (ein Schlupfbereich kann in ein Frequenzbereich umgerechnet werden). Der Schlupfbereich zwischen etwa 5% und etwa 10% enthält typische Schlupfwerte für Asynchronmaschinen mit Leistung zwischen etwa 5 KW und etwa 30 KW.

In anderen Worten wird bei der Ermittlung der Stromamplitude I(f,t) ein Phasenfilter angewandt, um zwischen tatsächlich erfassten Strömen und gestörten Stromsignaturamplituden, die durch Störungen/Rauschen beispielsweise durch Netzspannungsanteile sonstiger Verbraucher im Speisenetz entstehen können, zu unterscheiden und die gestörten Stromsignaturamplituden auszuschließen.

Das vorbestimmte Intervall kann beispielsweise Winkel zwischen etwa 40° und etwa 90° umfassen. Bei dem hier gezeigten Beispiel (Figuren 2 bis 4) des Verfahrens, bei welchem die Phasenbeziehung P_{UI} zwischen einem Strom- und einem Spannungsvektor ermittelt wird, kann der Phasenfilter für Winkel zwischen etwa 70° und etwa 90°, beispielsweise zwischen etwa 80° und etwa 90° gesetzt werden. Das Intervall soll im Allgemeinen so gewählt werden, dass die in dem Intervall enthaltenen Winkel eine Phase beschreiben, die zwischen den tatsächlich erfassten Strom- und Spannungsvektoren möglich ist beziehungsweise physikalisch Sinn macht.

Bei den vorgenannten gestörten Stromsignaturamplituden, die in etwa gleich groß wie die erfassten Stromamplituden sind, liegt die Phasenbeziehung bei dem in Fig 3 dargestellten Phasenbild in dem Bereich von etwa 20° bis 30°, sodass die gestörten Stromsignaturamplituden mittels des Phasenfilters herausgefiltert werden.

Die ermittelte Frequenzlage f_{L} ist für einen Zustand der elektrischen Maschine charakteristisch beziehungsweise ist die ermittelte Frequenzlage f_{L} einem (bestimmten) Zustand der elektrischen Maschine zugeordnet.

Nachdem der Zustand der Maschine aufgrund der ermittelten Frequenzlage f_{L} bestimmt wurde, kann die Maschine entsprechend gesteuert werden. Sollte zum Beispiel erkannt werden, dass der Zustand der Maschine aufgrund eines Rotorstabbruchs kritisch ist, kann die Maschine abgeschaltet werden. Sollte der Zustand der Maschine noch vertretbar sein aber erkannt werden, dass der kritische Zustand demnächst zu erwarten ist, kann beispielsweise eine entsprechende Warnmeldung herausgegeben werden.

Beispielsweise kann die Frequenzlage f_{L} bei Drehstrommaschinen einem der folgenden Fehlerzustände zugeordnet sein: Luftspaltexzentrizität, Rotorstabbruch (bei Asynchronmaschinen), Lagerbruch/-fehler, Statorwindungsfehler.

Außerdem kann der Frequenzlage f_{L} ein Lastzustand einer Drehstrommaschine zugeordnet sein.

Fig 4 zeigt ein Spektrogramm 101 mit der aufgetragenen ermittelten Frequenzlage f_{L}. Fig 4 veranschaulicht eine Verbesserung der Schlupferkennung 102 (Kreuze) gegenüber der klassischen Auswertung 103 (gestrichelte Linie) in einem zulässigen Schlupfbereich, beispielsweise zwischen 0 und Kippschlupf, vorzugsweise zwischen 5% und 10%, welcher durch Störfrequenzen behaftet ist. Diese Verbesserung wird durch Hinzunahme der vorgenannten Phaseninformation bei der Ermittlung der Frequenzlage erreicht.

Fig 5 eine weitere mögliche Phasenbeziehung P_{αβ}(f,t), die während des vorgenannten Schritts S2 des Verfahrens berechnet werden kann. Bei dem in Fig 5 dargestellten Phasenwinkel P_{αβ}(f,t) handelt es sich um einen Phasenwinkel zwischen zwei Phasenströmen I_{α} und I_{β}, die aus drei Phasenströmen I_{U}, I_{V}, I_{W}, einer dreiphasigen Drehstrommaschine mittels einer Clarke-Transformation erhalten werden können.

Die Phasenbeziehung P_{αβ}(f,t) kann beispielsweise in einem Frequenzbereich (f3, f4) zwischen etwa 1140 Hz (f3) und etwa 1151 Hz (f4) berechnet werden.

Die Frequenzlage f'_{L} entspricht einer PSH (7n). Das vorbestimmte Intervall (der Phasenfilter) umfasst Winkel zwischen etwa 40° und etwa 60°.

Fig 6 zeigt die ermittelte Frequenzlage f'_{L}. Darüber hinaus ist Fig 6 ein anhand der ermittelten Frequenzlage f'_{L} bestimmter Schlupf 104 (Kreuze) gegenüber der klassischen Auswertung 105 (gestrichelte Linie) in einem zulässigen Schlupfbereich, welcher durch Störfrequenzen, die beispielsweise auf vorhandene Seitenbanden 106 oder Spannungsänderungen zurückzuführen sind, behaftet ist, zu entnehmen.

Außerdem ist Fig 6 zu entnehmen, dass die ermittelte Frequenzlage f'_{L} auch Informationen über einen Lastzustand L1, L2, L3 zur Verfügung stellt und diesen sehr genauer lässt.

Das oben beschriebene Verfahren kann auch innerhalb mehrerer unterschiedlicher, vorzugsweise sich nicht überlappender, vorbestimmter Frequenzbereiche durchgeführt werden. Dabei kann in jedem Frequenzbereich jeweils eine Frequenzlage ermittelt werden, wobei unterschiedliche Frequenzlagen bzw. - linien für unterschiedliche Zustände der elektrischen Maschine charakteristisch sein können.

Der Zusammenschau der FIG 5 und FIG 6 ist weiterhin zu entnehmen, wie das vorbestimmte Intervall zur Auswahl der richtigen Frequenzlage verwendet wird. Eine Frequenzlage (die interessante Frequenzlinie = die "Hauptlinie") für die Beschreibung eines Zustandes (deren ungefähre Position z.B. anhand einer herkömmlichen MCSA Auswertung ermittelt werden kann) weist eine wohldefinierte absolute Phasenlage (in FIG 5 z.B. 60-80°, dunkel) auf, wohingegen Störlinien z.B. Seitenbandlinien (deutlich zu sehen in FIG 6) eine davon abweichende Phasenlage (in FIG5 0-20°, hell) aufweisen.

Die Auswahl eines "vorbestimmten" Phasenintervalls, in einem Frequenzband um die Hauptlinie herum, kann somit derart getroffen werden, dass die Unterscheidbarkeit zu Phasenlagen von störenden Linien ermöglicht, vorzugsweise vergrößert, insbesondere maximiert wird.

Das (Phasen-)Filter kann z.B. so realisiert werden, dass Y(f,t) = X(f,t)*Phasenfilter(f,t),
wobei Phasenfilter(f,t) = 0, wenn P(f,t) ausserhalb, Phasenfilter (f,t) = 1, wenn P(f,t) innerhalb des vorbestimmten Intervals. Dadurch können Störungen in der Amplitude weggefiltert werden, wobei die Gleichung Y(f,t)=X(f,t) da bestehen bleibt, wo Phasenlage der Hauptlinie liegt.

Fig 7 zeigt ein System 1 zur Zustandsüberwachung einer elektrischen Maschine, die beispielsweise als eine dreiphasige U, V, W Asynchronmaschine 2 ausgebildet ist. Das System 1 umfasst eine Messeinheit 3 zum Messen von Strömen und/oder Spannungen an der dreiphasigen Asynchronmaschine 2 und eine Recheneinheit 4. Die Recheneinheit 4 weist ein Computerprogramm 40 auf. Das Computerprogramm 40 kann auf einem computerlesbaren flüchtigen oder nichtflüchtigen Medium der Recheneinheit 4 vorliegen.

Das Computerprogramm 40 kann zwei Module 41, 42 umfassen, wobei das erste Modul 41 Instruktionen umfassen kann, die bei der Ausführung des ersten Moduls 41 durch die Recheneinheiten 4, diese veranlassen, spektrale Amplituden auf bekannten Schadfrequenzen beispielsweise mittels der Fourier-, oder Wavelet-Transformation durchzuführen auszuwerten. Das zweite Modul 42 kann dabei Instruktionen umfassen, die bei der Ausführung des zweiten Moduls 42 durch die Recheneinheiten 4 diese veranlassen, eine Frequenzlage f_{L}, f'_{L} gemäß den oben genannten Verfahrensschritten S1 bis S3 zu ermitteln und vorzugsweise den Schlupf und/oder den Lastzustand der Asynchronmaschine 2 zu bestimmen.

Jedes der Module 41 und 42 kann auch als ein Computerprogramm ausgebildet sein. Dabei kann es zweckmäßig sein, dem Computerprogramm 42 ein entsprechendes Spektrogramm 100 zur Verfügung zu stellen.

Obwohl die Erfindung im Detail durch Ausführungsbeispiele näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen. Insbesondere können die im Zusammenhang mit dem Verfahren beschriebenen Merkmale auch bei dem System zum Einsatz kommen bzw. dieses vervollständigen und *vice versa.*

## Patentansprüche

1. Computerimplementiertes Verfahren zur Zustandsüberwachung einer elektrischen Maschine (2), wobei innerhalb eines definierten Frequenzbereichs ((f1, f2), (f3,f4)) eine Frequenzlage (f_{L}, f'_{L}) derart ermittelt wird, dass bei der Frequenzlage (f_{L}, f'_{L}) eine Stromamplitude (I) maximal ist und eine Phasenbeziehung zwischen einem Strom- und einem Spannungsvektor (P_{UI}) oder zwischen zwei Stromvektoren (P_{αβ}) in einem vorbestimmten Intervall liegt, wobei die ermittelte Frequenzlage (f_{L}, f'_{L}) für einen Zustand der elektrischen Maschine (2) charakteristisch ist.

2. Verfahren nach Anspruch 1, wobei innerhalb mehrerer unterschiedlicher, vorzugsweise sich nicht überlappender, vorbestimmter Frequenzbereiche jeweils eine Frequenzlage ermittelt wird, wobei unterschiedliche Frequenzlagen für unterschiedliche Zustände der elektrischen Maschine charakteristisch sind.

3. Verfahren nach Anspruch 1 oder 2, wobei die elektrische Maschine eine Drehstrommaschine ist und der Zustand der Maschine ein Fehler- oder Betriebszustand ist.

4. Verfahren nach Anspruch 3, wobei die Drehstrommaschine eine Asynchronmaschine (2) ist und der Frequenzbereich durch einen Schlupfbereich zwischen 0 und Kippschlupf bestimmt wird, insbesondere durch einen Schlupfbereich zwischen 5% und 10% bestimmt wird.

5. Verfahren nach Anspruch 3, wobei die Drehstrommaschine eine Synchronmaschine ist und der Zustand ein Fehlerzustand ist.

6. Verfahren nach einem der Ansprüche 3 bis 5, wobei die Phasenbeziehung eine Phasenbeziehung (P_{αβ}) zwischen einem α- und einem β-Stromvektor ist.

7. Verfahren nach einem der Ansprüche 1 bis 6, wobei das vorbestimmte Intervall ein Intervall zwischen 40° und 90°, insbesondere zwischen 40° und 60° oder zwischen 70° und 90° ist.

8. Verfahren nach einem der Ansprüche 1 bis 7, wobei die Phasenbeziehung (P_{UT}, (P_{αβ}) unter Verwendung von Admittanz oder Impedanz ermittelt wird.

9. Verfahren nach einem der Ansprüche 1 bis 8, wobei die Stromamplitude mit einer vorbestimmten Messzeit gemessen wird, die beispielsweise zwischen etwa 0,1 Sekunde und 10 Sekunden, beispielsweise zwischen etwa 1 Sekunde bis 10 Sekunden, vorzugsweise zwischen etwa 1 Sekunde bis 5 Sekunden, insbesondere 1 Sekunde beträgt.

10. Computerprogrammcode, umfassend Befehle, die bei der Ausführung des Programmcodes (42) durch einen Computer (4) diesen veranlassen, ein Verfahren nach einem der Ansprüche 1 bis 9 auszuführen.

11. System zur Zustandsüberwachung einer elektrischen Maschine, wobei das System (1) eine Recheneinheit (4) umfasst, wobei die Recheneinheit (4) einen Computerprogrammcode (42) nach Anspruch 10 aufweist.

12. System nach Anspruch 11, wobei das System (1) zusätzlich eine Messeinheit (3) zur Messung von Strom und/oder Spannung einer dreiphasigen Drehstrommaschine aufweist.

13. Datenträgersignal, das den Computerprogrammcode nach Anspruch 10 überträgt.

## Claims

1. Computer-implemented method for monitoring the state of an electric machine (2), wherein, within a defined frequency range ((f1, f2), (f3, f4)), a frequency position (f_{L}, f'_{L}) is determined such that a current amplitude (I) is at a maximum at the frequency position (f_{L}, f'_{L}) and a phase relationship between a current vector and a voltage vector (P_{UI}) or between two current vectors (P_{αβ}) lies in a predefined interval, wherein the determined frequency position (f_{L}, f'_{L}) is characteristic of a state of the electric machine (2).

2. Method according to claim 1, wherein, within a plurality of different, preferably non-overlapping, predefined frequency ranges, a frequency position is determined in each case, wherein different frequency positions are characteristic of different states of the electric machine.

3. Method according to claim 1 or 2, wherein the electric machine is a three-phase machine and the state of the machine is a fault condition or an operating state.

4. Method according to claim 3, wherein the three-phase machine is an asynchronous machine (2) and the frequency range is determined by means of a slip range between 0 and breakdown slip, in particular by means of a slip range between 5% and 10%.

5. Method according to claim 3, wherein the three-phase machine is a synchronous machine and the state is a fault condition.

6. Method according to one of claims 3 to 5, wherein the phase relationship is a phase relationship (P_{αβ}) between an α and a β current vector.

7. Method according to one of claims 1 to 6, wherein the predefined interval is an interval between 40° and 90°, in particular between 40° and 60° or between 70° and 90°.

8. Method according to one of claims 1 to 7, wherein the phase relationship (P_{UI}, (P_{αβ}) is determined using admittance or impedance.

9. Method according to one of claims 1 to 8, wherein the current amplitude is measured over a predefined measurement time which amounts for example to between approx. 0.1 second and 10 seconds, for example between approx. 1 second and 10 seconds, preferably between approx. 1 second and 5 seconds, in particular 1 second.

10. Computer program code comprising commands which, when the program code (42) is executed by a computer (4), cause the latter to perform a method according to one of claims 1 to 9.

11. System for monitoring the state of an electric machine, wherein the system (1) comprises a computing unit (4), wherein the computing unit (4) has a computer program code (42) according to claim 10.

12. System according to claim 11, wherein the system (1) additionally has a measurement unit (3) for measuring the current and/or voltage of a three-phase machine.

13. Data carrier signal which transmits the computer program code according to claim 10.

## Revendications

1. Procédé mis en œuvre par ordinateur de contrôle de l'état d'une machine (2) électrique, dans lequel dans une plage ((f1, f2), (f3, f4)) de fréquence définie, on recherche une position (f_{L}, f'_{L}) de la fréquence, de manière à avoir, à la position (f_{L}, f'_{L}) de la fréquence, une amplitude (I) de courant maximum et de manière à ce qu'une relation de phase entre un vecteur (P_{UI}) de courant et un vecteur de tension ou entre deux vecteurs (P_{αβ}) de courant se trouve dans un intervalle déterminé à l'avance, dans lequel la position (f_{L}, f'_{L}) de la fréquence recherchée est caractéristique d'un état de la machine (2) électrique.

2. Procédé suivant la revendication 1, dans lequel on recherche respectivement une position de la fréquence dans plusieurs plages de fréquence déterminées à l'avance, différentes, de préférence ne se chevauchant pas, dans lequel des positions différentes de la fréquence sont caractéristiques d'états différents de la machine électrique.

3. Procédé suivant la revendication 1 ou 2, dans lequel la machine électrique est une machine à courant triphasé et l'état de la machine est un état défectueux ou un état de fonctionnement.

4. Procédé suivant la revendication 3, dans lequel la machine à courant triphasé est une machine (2) asynchrone et on détermine la plage de fréquence par une plage de glissement entre 0 et un glissement au décrochage, en particulier par une plage de glissement entre 5% et 10%.

5. Procédé suivant la revendication 3, dans lequel la machine à courant triphasé est une machine synchrone et l'état est un état défectueux.

6. Procédé suivant l'une des revendications 3 à 5, dans lequel la relation de phase est une relation (P_{αβ}) de phase entre un vecteur de courant α et un vecteur de courant β.

7. Procédé suivant l'une des revendications 1 à 6, dans lequel l'intervalle déterminé à l'avance est un intervalle compris entre 40° et 90°, en particulier entre 40° et 60° ou entre 70° et 90°.

8. Procédé suivant l'une des revendications 1 à 7, dans lequel on recherche la relation (P_{UI}), (P_{αβ}) de phase en utilisant de l'admittance ou de l'impédance.

9. Procédé suivant l'une des revendications 1 à 8, dans lequel on mesure l'amplitude de courant avec un temps de mesure déterminé à l'avance, qui est compris par exemple entre 0,1 seconde et 10 secondes, par exemple entre environ 1 seconde et 10 secondes, de préférence entre environ 1 seconde et 5 secondes, en particulier d'1 seconde.

10. Code de programme d'ordinateur comprenant des instructions qui, lors de l'exécution du code (42) de programme par un ordinateur (4), font que celles-ci exécutent un procédé suivant l'une des revendications 1 à 9.

11. Système de contrôle de l'état d'une machine électrique, dans lequel le système (1) comprend une unité (4) informatique, l'unité (4) informatique ayant un code (42) de programme d'ordinateur suivant la revendication 10.

12. Système suivant la revendication 11, dans lequel le système (1) comporte en outre, une unité (3) de mesure pour la mesure du courant et/ou de la tension d'une machine à courant triphasé.

13. Signal porteur de données, qui transmet le code de programme d'ordinateur suivant la revendication 10.
